# EUROPEAN PATENT APPLICATION

(11) **EP 4 772 771 A1**
(43) Date of publication of application: **08.07.2026**
(21) Application number: 23954694.8
(22) Date of filing: 02.10.2023
(51) Int. Cl.: F16J 9/26

(54) **SLIDING MEMBER AND PISTON RING**

(71) Applicant: NPR-RIKEN CORPORATION, Tokyo 102-8202 (JP)
(72) Inventor: TAKAYA Masaaki, Tokyo 102-8202 (JP); MARUYAMA Hiroshi, Tokyo 102-8202 (JP)
(74) Representative: Scott, Stephen John
(86) International application number: PCT/JP2023/035968
(87) International publication number: WO 2025/074480

(57) **Abstract**

Provided are a sliding member and a piston ring, with a DLC coating, that have excellent wear resistance even when used in a boundary lubrication environment. The sliding member according to the present disclosure is a sliding member including a base member and a DLC coating that is substantially free of hydrogen and is formed on a surface of the base member. The central wave number of the G band in the Raman spectrum of the DLC coating obtained by Raman spectroscopy using a laser in the visible region as excitation light is 1585 cm⁻¹ or more, and a hardness H_{IT} of the DLC coating, obtained by nanoindentation and expressed in gigapascals, is 15 GPa or more and 35 GPa or less.

## Description

### TECHNICAL FIELD

The present disclosure relates to a sliding member and a piston ring.

### BACKGROUND

A piston ring is a type of sliding member and is a component attached to the piston of an internal combustion engine to maintain airtightness between the piston and the cylinder. Two or three piston rings are attached near the head of the piston to create a seal so that the combustion gases generated in the cylinder do not leak out to the crankshaft side. The piston ring also has the function of controlling the thickness of the film of engine oil formed on the inner wall of the cylinder. Furthermore, the piston ring has the function of releasing the combustion heat received by the piston to the cylinder.

In addition to these basic functions, piston rings are also required to be durable. In particular, the outer circumferential surface of the piston ring rubs against the inner wall of the cylinder as the piston reciprocates and is thus required to have wear resistance. In order to reduce sliding friction between the piston ring and the inner wall of the cylinder, the formation of a hard carbon coating on the surface of the piston ring base member has been investigated.

For example, Patent Literature (PTL) 1 describes a member in which a hard carbon layer made of diamond-like carbon (hereinafter sometimes referred to as "DLC") is formed on the surface of a base member, and when the hard carbon layer is measured by Raman spectroscopy, ID/IG, which is the area intensity ratio of the peaks of the D band to the G band in the Raman spectrum, is 1 to 6. Furthermore, PTL 2 describes a member in which hard carbon layers made of two types of DLC with different properties are alternately laminated on the surface of a base member. These hard carbon layers according to conventional techniques are all formed by applying a bias voltage to the base member and heating the base member with a heater at the same time.

### CITATION LIST

### Patent Literature

PTL 1: JP 2018-123431 A

PTL 2: WO 2017/104822 Al

### SUMMARY

### (Technical Problem)

In conventional techniques, one method of increasing the durability of piston rings has been to form a DLC coating with as high a hardness as possible on the surface of the base member of the piston ring. By providing the piston ring with a very hard DLC coating on its surface, wear of the DLC coating on the outer circumferential surface of the piston ring that rubs against the inner wall of the cylinder can effectively be prevented. This was thought to extend the life of the piston rings, thereby reducing the frequency of piston ring replacement.

In recent automobile engines, there is a tendency toward increasing the gasoline combustion temperature inside the cylinders, using engine oil with lower viscosity than before, and reducing the amount of engine oil used, in order to meet demands for higher output and stricter exhaust gas regulations. With these new technological trends, the lubrication between the outer circumferential surface of the piston ring and the inner wall of the cylinder is changing from a fluid lubrication environment, in which a continuous oil film made of engine oil has conventionally been formed, to a boundary lubrication environment, in which direct metal-to-metal contact occurs locally in areas where the oil film is thin.

According to our research, when a piston ring having a very hard DLC coating on its surface is used in a boundary lubrication environment, the wear of the DLC coating on the outer circumferential surface of the piston ring is more likely to progress than in a fluid lubrication environment. This suggests that for piston rings used in a boundary lubrication environment, it is difficult to ensure the wear resistance required for the piston rings by simply increasing the hardness of the DLC coating, as has been done in the past.

Furthermore, in conventional techniques, the thickness of the DLC coating must be increased to a certain extent when attempting to increase the durability of a piston ring by using a DLC coating with high hardness. This leads to the problem of increased costs to manufacture the piston ring, since it takes time to form the DLC coating.

It is an aim of the present disclosure, conceived in light of the aforementioned problems, to provide a sliding member and a piston ring, with a DLC coating, that have excellent wear resistance even when used in a boundary lubrication environment.

### (Solution to Problem)

The primary features of the present disclosure are as follows.
[1] A sliding member comprising a base member and a DLC coating that is substantially free of hydrogen and is formed on a surface of the base member, wherein
   a central wave number of a G band in a Raman spectrum of the DLC coating obtained by Raman spectroscopy using a laser in a visible region as excitation light is 1585 cm⁻¹ or more, and
   a hardness H_{IT} of the DLC coating, obtained by nanoindentation and expressed in gigapascals, is 15 GPa or more and 35 GPa or less.
[2] The sliding member according to [1], wherein E_{IT} is an elastic modulus of the DLC coating, obtained by nanoindentation and expressed in gigapascals, and a ratio H_{IT}/E_{IT} of the hardness H_{IT} to the elastic modulus E_{IT} is 0.095 or more.
[3] The sliding member according to [1] or [2], comprising an intermediate layer between the base member and the DLC coating, the intermediate layer being made of one or more elements selected from the group consisting of Cr, Ti, Co, V, Mo, Si, and W, or made of a carbide, nitride, or carbonitride thereof.
[4] A piston ring comprising the sliding member according to any one of [1] to [3].

### (Advantageous Effect)

According to the present disclosure, the amount of sliding wear of the DLC coating when a sliding member having a DLC coating slides against a mating member is reduced compared to conventional techniques. This improves the wear resistance of the sliding member. Furthermore, the thickness of the DLC coating can be reduced compared to conventional techniques.

### BRIEF DESCRIPTION OF THE DRAWINGS

In the accompanying drawings:
FIG. 1 is a schematic diagram illustrating an example of the cross-sectional shape of a sliding member;
FIG. 2 is a schematic diagram illustrating an example of the cross-sectional shape of a base member of a piston ring;
FIG. 3 is a schematic diagram illustrating the structure of a sliding wear tester;
FIG. 4 is a graph illustrating the relationship between the central wave number of the G band in the Raman spectrum of a DLC coating obtained by Raman spectroscopy and the sliding friction amount ratio;
FIG. 5 is a graph illustrating the relationship between the hardness of the DLC coating obtained by nanoindentation and the sliding friction amount ratio;
FIG. 6 is a graph illustrating the relationship between the ratio of hardness to elastic modulus of the DLC coating and the sliding friction amount ratio; and
FIG. 7 is a graph illustrating the relationship between the area intensity ratio ID/IG of the peaks of the D band and the G band in the Raman spectrum of the DLC coating, obtained by Raman spectroscopy, and the sliding friction amount ratio.

### DETAILED DESCRIPTION

Hereinafter, embodiments of the present disclosure will be described in detail.

### [Sliding member]

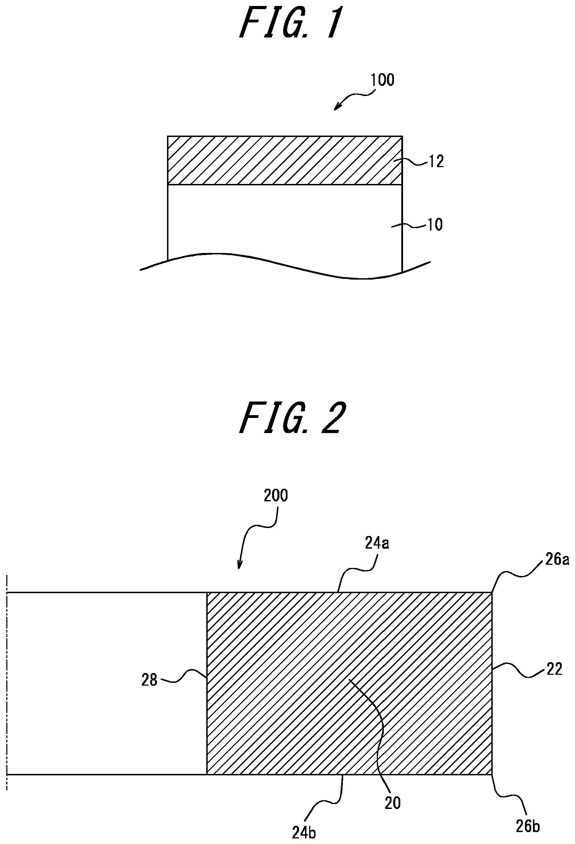

In one embodiment, a sliding member is disclosed in the present disclosure. FIG. 1 is a schematic diagram illustrating an example of the cross-sectional shape of the sliding member according to the present disclosure. The sliding member 100 has a base member 10 and a DLC coating 12 that is substantially free of hydrogen and is formed on a surface of the base member 10. The sliding member 100 according to the present disclosure has excellent wear resistance and can therefore be applied to various products, such as piston rings, pistons, piston pins, tappets, valve lifters, shims, rocker arms, cams, camshafts, timing gears, timing chains, and the like used in sliding parts of internal combustion engines where lubricating oil such as engine oil is present, and in vanes, injectors, plungers, cylinders, and the like used in fuel supply systems.

### [Base member]

The sliding member according to the present disclosure has a base member and a DLC coating that is substantially free of hydrogen and is formed on a surface of the base member. The base member is a member that becomes the main body of the sliding member. The material forming the base member in the sliding member according to the present disclosure and the shape of the base member may be any material and shape, as long as the material and shape allow for the formation of a DLC coating on the surface.

### [DLC coating]

The sliding member according to the present disclosure has a DLC coating formed on the surface of the base member. The DLC coating is a film made of diamond-like carbon, which is amorphous carbon that exhibits properties similar to those of diamond. The DLC coating of the sliding member according to the present disclosure may be formed directly on the surface of the base member or may be formed on the surface of one or more intermediate layers formed on the surface of the base member.

The DLC coating of the sliding member according to the present disclosure is substantially free of hydrogen. In the present specification, the term "DLC coating that is substantially free of hydrogen" means that the amount of hydrogen contained in the diamond-like carbon that constitutes the DLC coating is 2.0 % or less in atomic percentage. The DLC coating becomes softer when it contains hydrogen. In the present disclosure, by adopting a DLC coating that is substantially free of hydrogen as the DLC coating on the sliding member, the hardness required for the DLC coating stipulated by the present disclosure, as described later, can be ensured. The amount of hydrogen contained in the DLC coating is preferably 1.0 % or less in atomic percentage and more preferably 0.5 % or less.

### [Method of measuring the amount of hydrogen contained in the DLC coating]

The amount of hydrogen contained in the DLC coating can be measured by Rutherford Backscattering Spectrometry (RBS)/Hydrogen Forward Scattering Spectrometry (HFS) for DLC coatings formed on sliding members with a flat surface or a surface with a sufficiently large curvature. RBS/HFS is a known method for analyzing film composition but cannot be applied to the analysis of non-flat surfaces. Therefore, for a DLC coating formed on a non-flat sliding surface, such as the outer circumferential surface of a piston ring, the hydrogen content can be measured by combining RBS/HFS and Secondary Ion Mass Spectrometry (SIMS). The procedure is explained below.

First, a DLC coating to be used as the reference value measurement target is formed on a mirror-polished flat test piece (a hardened SKH51 disk, diameter 25 × thickness 5 mm, hardness HRC 60 to 63) serving as a reference sample with a flat surface. The film is formed on the reference sample using reactive sputtering and introducing C₂H₂, Ar, and H₂ as atmospheric gases. The amount of hydrogen contained in the DLC coating is adjusted by changing the flow rate of the introduced H₂ and/or C₂H₂. In this way, DLC coatings formed by hydrogen and carbon and having different hydrogen contents are formed, and the hydrogen and carbon contents of these films are evaluated by RBS/HFS.

Next, the above sample is analyzed by SIMS to measure the secondary ion intensities of hydrogen and carbon. Here, SIMS analysis can also be used to measure a DLC coating formed on a non-flat surface, such as the outer circumferential surface of a piston ring. Therefore, for the same coating of a reference sample coated with a DLC coating, an empirical formula (measurement curve) is determined to indicate the relationship between the hydrogen content and carbon content (unit: atomic %) obtained by RBS/HFS and the ratio of the secondary ion intensities of hydrogen and carbon obtained by SIMS. In this way, the hydrogen content and carbon content can be calculated from the secondary ion intensities of hydrogen and carbon measured by SIMS on the outer circumferential surface of an actual piston ring. The average value of the secondary ion intensity of each element observed at least at a depth of 20 nm or more from the surface of the DLC coating and within an area of 50 nm square is adopted as the value of the secondary ion intensity by SIMS.

### [DLC coating formation method]

In the present disclosure, in order to form a DLC coating that is substantially free of hydrogen on the surface of the base member of the sliding member, the DLC coating may be formed by, for example, a PVD method such as an ion plating method based on vacuum arc discharge using a carbon target. The PVD method can form a DLC coating that contains almost no hydrogen, has high hardness, and is highly wear-resistant. A filtered cathodic vacuum arc method (FCVA method) equipped with a filter for removing carbon microparticles is preferably used. However, the method for forming a DLC coating that is substantially free of hydrogen is not limited to these methods.

The DLC coating may be formed on at least a portion of the surface of the base member or may be formed over the entire surface of the base member. When the DLC coating is formed on a portion of the surface of the base member, the DLC coating is preferably formed on a portion, of the surface of the sliding member, that is particularly required to have wear resistance. In this case, the surface of the formed DLC coating constitutes the sliding surface of the sliding member.

### [Central wave number of the G band]

In the DLC coating of the sliding member according to the present disclosure, the central wave number of the G band in a Raman spectrum of the DLC coating obtained by Raman spectroscopy using a laser in the visible region as excitation light is 1585 cm⁻¹ or more. The Raman spectrum of the DLC coating can be obtained by using Raman spectroscopy to measure a sliding member having a DLC coating formed on its surface. When measuring the Raman spectrum, laser light in the visible range is used as the excitation light. In the case of measuring the Raman spectrum for each portion of the sliding member, a micro-Raman spectrometer can be used.

The G band in the Raman spectrum of the DLC coating is associated with the sp² bond component of the bonds between carbon atoms contained in the DLC coating and is thought to change in response to changes in the crystal structure of graphite. The central wave number of the G band in the present disclosure was determined by the following procedure. First, the background was subtracted from the obtained Raman spectrum in the range of 900 cm⁻¹ to 1900 cm⁻¹. The peak around 1350 cm⁻¹ was then assumed to be the D band, the peak around 1550 cm⁻¹ was assumed to be the G band, and fitting was performed using two Gaussian functions. Next, the wave number at the peak position in the spectrum of the separated G band was determined, and this wave number was taken as the central wave number of the G band.

In the present disclosure, the central wave number of the G band in the Raman spectrum of the DLC coating is 1585 cm⁻¹ or more. When the DLC coating on the sliding member satisfies this condition, the amount of wear when sliding friction occurs between the sliding member and a mating member is reduced compared to a sliding member having a DLC coating according to a conventional technique, which serves as the standard for comparison.

The reason why the amount of wear of a DLC coating on a sliding member, when sliding friction occurs between the sliding member and a mating member, decreases when the central wave number of the G band in the Raman spectrum of the DLC coating is 1585 cm⁻¹ or more is not clearly understood, but a likely reason is thought to be as follows. As described above, it is thought that the central wave number of the G band changes in accordance with changes in the crystal structure of the graphite contained in the DLC coating. It is speculated that, due to the load and heat generated by sliding, a protective film called a tribofilm is more likely to form on the surface of the DLC coating, and abrasive wear, a phenomenon in which the surface is scraped away by foreign matter present between the frictional surfaces, is suppressed.

It suffices for the value of the central wave number of the G band to be 1585 cm⁻¹ or more, and there is no particular upper limit. However, it is thought that there is a limit to the amount of shift in the G band that accompanies a change in the crystal structure of graphite. Therefore, the value of the central wave number of the G band is substantially limited to 1610 cm⁻¹ or less.

### [Hardness of DLC coating]

In the sliding member according to the present disclosure, the hardness H_{IT} of the DLC coating, obtained by nanoindentation and expressed in gigapascals, is 15 GPa or more and 35 GPa or less. In the present specification, the term "nanoindentation" refers to a measurement method based on the nanoindentation hardness test method defined in the international standard ISO14577. In this method, a tiny diamond indenter with a regular triangular pyramid (Berkovich type) tip is pressed into the surface of a sample, and the hardness and elastic modulus of a microscopic area can be measured by measuring the load-displacement curve at the time of indentation. To avoid the influence of the base member that is the base of the DLC coating, the indentation load is set so that the maximum indentation depth of the diamond indenter is 1/10 or less of the coating thickness. In addition, as pretreatment for the test, mirror polishing is performed on the test location to reduce the variation in test values.

It is known that the hardness H_{IT} of a DLC coating measured by nanoindentation varies greatly depending on the conditions under which the DLC coating is formed. For example, the hardness of graphite is about 4 GPa, and the hardness of diamond is 90 GPa to 100 GPa. The hardness H_{IT} of the DLC coating of the sliding member according to the present disclosure is between these values.

If the hardness H_{IT} of the DLC coating is less than 15 GPa, the amount of wear of the DLC coating increases when sliding friction occurs with the sliding member. If the hardness H_{IT} of the DLC coating is greater than 35 GPa, abrasive wear is more likely to occur due to the generation of wear particles, and the amount of wear of the DLC coating thus increases in this case as well. Therefore, if the hardness H_{IT} of the DLC coating is too small or too large, the amount of wear of the DLC coating increases. When the hardness H_{IT} of the DLC coating is in the range of 15 GPa or more and 35 GPa or less as specified in the present disclosure, the wear amount of the DLC coating is reduced to half or less as compared to the DLC coating according to a conventional technique, which is the standard for comparison.

### [Thickness of DLC coating]

In a preferred embodiment, the thickness of the DLC coating on the sliding member according to the present disclosure is not particularly limited but is preferably 1.0 µm or more and 30 µm or less. A thickness of 1.0 µm or more achieves sufficient durability of the DLC coating, and a thickness of 30 µm or less achieve sufficient adhesion to the base member, thereby preventing peeling. The thickness of the DLC coating is more preferably 5.0 µm or more and 20.0 µm or less. The thickness of the DLC coating can be measured by the Calotest or by observing a cross-section of the coating embedded in resin.

### [Ratio of DLC coating hardness to elastic modulus]

In a preferred embodiment, E_{IT} is the elastic modulus of the DLC coating, obtained by nanoindentation and expressed in gigapascals, and the ratio H_{IT}/E_{IT} of the hardness H_{IT} to the elastic modulus E_{IT} is 0.095 or more. The elastic modulus E_{IT} of the DLC coating is an index that indicates the resistance of the DLC coating to elastic deformation when a load is applied to the DLC coating. The smaller the elastic modulus E_{IT} of the DLC coating, the more flexibly the DLC coating deforms when the sliding member having the DLC coating is pressed against a mating member. Therefore, when comparing when the hardness H_{IT} is the same, it is thought that the larger the ratio H_{IT}/E_{IT}, the more flexibly the DLC coating deforms, thereby suppressing the progress of abrasive wear of the DLC coating.

In the preferred embodiment, it suffices for the ratio H_{IT}/E_{IT} of the hardness to the elastic modulus of the DLC coating to be 0.095 or more, and there is no particular upper limit. In general, there is a certain correlation between the elastic modulus and hardness of a material. For this reason, the ratio H_{IT}/E_{IT} of hardness to elastic modulus expressed in the same units for a DLC coating that is substantially free of hydrogen is limited to substantially 0.120 or less.

### [Intermediate layer]

In a preferred embodiment, the sliding member according to the present disclosure further includes an intermediate layer between the base member and the DLC coating, the intermediate layer being made of one or more elements selected from the group consisting of Cr, Ti, Co, V, Mo, Si, and W, or made of a carbide, nitride, or carbonitride thereof. The intermediate layer is provided on at least a portion of the surface of the base member. The presence of the intermediate layer on the surface of the base member relieves stress between the base member and the DLC coating, improving the adhesion of the DLC coating.

The intermediate layer may coat at least a part of the surface of the base member or may coat the entire surface. When a piston ring is selected as the base member of the sliding member, for example, the outer circumferential surface of the piston ring can be coated. This configuration is preferable, as it improves the adhesion of the DLC coating to the outer circumferential surface. In the case of coating the entire surface of the base member, the intermediate layer coating the entire surface of the base member may be left as is, or after the intermediate layer is formed, unnecessary portions thereof may be removed by polishing or the like to expose the base member.

The thickness of the intermediate layer is preferably 0.1 µm or more and 0.6 µm or less, more preferably 0.2 µm or more and 0.5 µm or less. If the thickness is 0.1 µm or more, the adhesion of the DLC coating can be improved, and if the thickness is 0.6 µm or less, the intermediate layer is less likely to undergo plastic flow during sliding, making the DLC coating less likely to peel off. The intermediate layer can be formed on the base member by, for example, suitably using a known physical vapor deposition (PVD) method.

### [Piston ring]

Another embodiment of the present disclosure is a piston ring. The piston ring according to the present disclosure is a piston ring made of the sliding member according to the present disclosure. The base member of the piston ring according to the present disclosure is made of steel having a ring shape. The steel used for the base member is not particularly limited as long as it has the necessary properties for a piston ring, such as the necessary strength, elastic modulus, and thermal conductivity. Carbon steel, spring steel, martensitic stainless steel, or the like is preferably used as the steel. The piston ring according to the present disclosure has a ring shape, and a gap is provided in a part of the ring shape. In a state in which the gap is closed and the diameter is reduced, the piston ring is fitted in a groove provided on the outer circumferential surface of the piston. Inside the cylinder, the outer circumferential surface of the piston ring slides while being pressed against the inner wall of the cylinder by tension.

FIG. 2 is a schematic view illustrating an example of the cross-sectional shape of the base member of a piston ring according to the present disclosure. The below-described DLC coating is omitted from FIG. 2. As illustrated in FIG. 2, a piston ring 200 includes a base member 20 having a cross-section that approximates a rectangle. However, the cross-sectional shape of the base member 20 that forms the piston ring encompasses many variations and does not need to be rectangular.

When the piston ring 200 is fitted in a groove of a non-illustrated piston, an outer peripheral surface 22 is located further outward than the outer peripheral surface of the piston and slides in contact with the inner wall of the cylinder. The shape of the outer peripheral surface 22 may be a flat shape as illustrated in FIG. 2, a barrel shape with the central portion bulging outward, or a tapered shape with the diameter continuously changing depending on the position. As described above, the outer peripheral surface 22 is required to have abrasion resistance that reduces wear due to sliding against the inner wall surface of the cylinder. In the piston ring according to the present disclosure, a non-illustrated DLC coating is formed on the outer peripheral surface 22.

Side surfaces 24a and 24b are surfaces where the piston ring 200 comes into contact with the non-illustrated groove in the piston. An upper side surface 24a and a lower side surface 24b are illustrated in FIG. 2. Opposite the outer peripheral surface 22 is an inner peripheral surface 28. Outer peripheral edges 26a and 26b exist at the boundaries between the outer peripheral surface 22 and the side surfaces 24a and 24b. Generally, the outer peripheral edges 26a, 26b are provided with a non-illustrated chamfer to prevent chipping of the base member 20.

### [Sliding fatigue test]

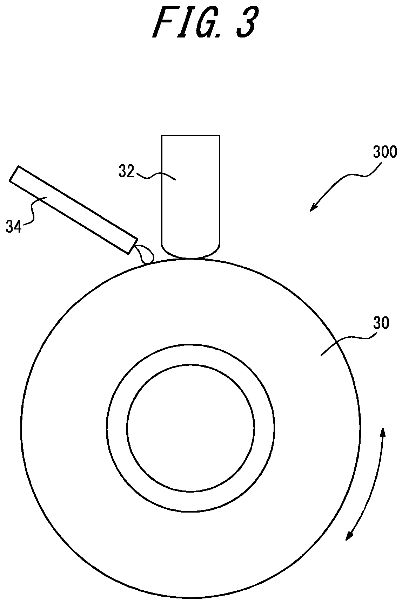

A method of evaluating the amount of wear of the DLC coating on the sliding member according to the present disclosure when sliding friction is generated between the sliding member and a mating member will be described. FIG. 3 is a schematic diagram illustrating an outline of the method of carrying out the sliding fatigue test for this evaluation. A sliding fatigue tester 300 used for the sliding fatigue test has a rotating drum 30. The sliding fatigue tester 300 applies a load repeatedly while pressing the surface of a test piece 32 against the outer circumferential surface of the drum 30 using a non-illustrated drive mechanism. The amount of wear of the DLC coating formed on the surface of the test piece 32 is determined by measuring the change in the dimensions of the test piece 32 before and after the test. The sliding wear ratio is obtained by dividing this amount by the amount of wear of a standard sample subjected to the same conditions.

Example test conditions for carrying out the sliding fatigue test are illustrated below. The drum 30, which is the mating member against which the test piece 32 slides, is a cylindrical member having a diameter of 80 mm. The material constituting the drum 30 is preferably a steel with high wear resistance. For example, bearing steel of steel type number SUJ2 specified in Japanese Industrial Standard JIS G 4805 "High carbon chromium bearing steels" can be used. The speed of the circumferential surface of the drum 30 rotating relative to the fixed test piece 32 is set to 10.0 m/s. The drum 30 rotates by accelerating from a stationary state to a speed of 10.0 m/s in 30 seconds, maintaining the speed at 10.0 m/s for 20 seconds, and then decelerating to zero speed in 30 seconds. Next, the rotation direction is reversed, and acceleration, holding, and deceleration are performed to constitute one cycle, which is repeated 10 times.

A load is repeatedly applied to the test piece 32 by a non-illustrated driving mechanism, and the test piece 32 is pressed perpendicularly against the outer circumferential surface of the drum 30. The magnitude of the load is set to a maximum load of 50 N and a minimum load of 20 N, and the load is changed over time between the maximum load and the minimum load in a sinusoidal wave shape with a frequency of 50 Hz. The surface temperature of the drum 30 is maintained at 80 °C by a non-illustrated heater. Motor oil without additives is supplied from the tip of an oil supply pipe 34 to the surface of the drum 30 at a rate of 0.1 cm³ per minute. This oil supply rate is insufficient for fluid lubrication, creating a boundary lubrication environment.

### EXAMPLES

The present disclosure will be described below with reference to examples, but the present disclosure is not limited to these examples.

As base members for piston rings, base members made of silicon chromium steel and having a ring shape with an approximately rectangular cross-section were prepared. The base member had a nominal diameter of 78 mm, a thickness of 2.5 mm, and a width of 1.2 mm. The shape of the outer peripheral surface was a barrel face with a slight bulge in the center. The outer peripheral edges of the base member were provided with a 0.15 mm wide chamfer. Using a cathodic arc ion plating device (M720, manufactured by Nippon ITF Inc.), the outer circumferential surface of the base members was coated with an intermediate layer made of chromium and having a thickness of 0.5 µm.

Next, after being degreased and washed, the base members were set in the cathodic arc ion plating device with their sides in contact with each other. The surfaces was cleaned by ion bombardment treatment, and then the outer circumferential surfaces of the base members were coated with a DLC coating using an ion plating method with vacuum arc discharge. After the DLC coating was formed, any DLC coating that had spread around to the side surfaces was removed using a honing apparatus and a lapping apparatus, thereby obtaining the plurality of piston rings of Examples 1 to 5 and Comparative Examples 1 to 9 listed in Table 1. The conditions for forming the DLC coating are listed in Table 1.

**[Table 1]**

| | Coating formation conditions | | | | | |
|---|---|---|---|---|---|---|
| | Arc current (A) | Set bias (V) | Measured bias (V) | Heating with a heater | Base member temperature (°C) | Coating formation speed |
| Example 1 | 200 | 0 | -35 | no | 210 | equivalent |
| Example 2 | 175 | 0 | -32 | no | 220 | equivalent |
| Example 3 | 125 | 0 | -12 | no | 250 | fast |
| Example 4 | 125 | 0 | -12 | no | 233 | fast |
| Example 5 | 125 | floating potentialization | 0 | no | 250 | fast |
| Comparative Example 1 | 70 | 0 | -9 | yes | 200 | equivalent |
| Comparative Example 2 | 70 | 0 | -9 | yes | 300 | equivalent |
| Comparative Example 3 | 70 | 0 | -9 | no | 170 | equivalent |
| Comparative Example 4 | 70 | -50 | -50 | no | 210 | equivalent |
| Comparative Example 5 | 70 | 0 | -9 | no | 110 | slow |
| Comparative Example 6 | 105 | 0 | -11 | no | 210 | fast |
| Comparative Example 7 | 105 | 0 | -11 | yes | 230 | fast |
| Comparative Example 8 | 135 | 0 | -15 | no | 257 | fast |
| Comparative Example 9 | 135 | -50 | -50 | no | 310 | fast |

The set bias listed in Table 1 is the bias voltage of the base member set on the apparatus during coating formation. Regardless of the set bias value, the bias voltage holding circuit included in the apparatus functions to hold the bias voltage at the set bias value. The measured bias listed in Table 1 is the bias voltage of the base member that was actually monitored during coating formation. Even if the set bias is set to zero, the base member is charged by the charge carried by the carbon ions, and a non-zero bias voltage is measured. This is sometimes called the self-bias voltage. The self-bias voltage accelerates the carbon ions, increasing their energy, and the temperature of the base member tends to rise even when not heated by a heater.

As illustrated in Examples 1 to 4, when the absolute value of the self-bias voltage is greater than the absolute value of the set bias, the measured bias voltage is dominated by the self-bias voltage and is not affected by the set bias. Furthermore, when the set bias is the same, the measured bias changes depending on the magnitude of the arc current.

The term "floating potentialization" in Example 5 means that the bias voltage holding circuit of the apparatus is cut off, and the bias voltage is not controlled. In this case as well, the base member is charged by the charge carried by the carbon ions.

Regarding the coating formation rates illustrated in Table 1, "fast" indicates a coating formation rate faster than the conditions of Comparative Example 1, which is used as a reference; "equivalent" indicates an equivalent coating formation rate; and "slow" indicates a slower coating formation rate.

The piston ring samples thus obtained were subjected to the following evaluations. First, the Raman spectrum of the DLC coating on the outer circumferential surface of the piston ring was measured using a Raman spectrometer (manufactured by Renishaw, inViaReflex). Measurement was performed under the conditions of an Ar ion excitation laser wavelength of 532.0 nm, a laser output of 50 mW, a 100x objective lens, and passage through a light attenuator. From the obtained Raman spectrum data, the central wave number of the G band and ID/IG, which is the area intensity ratio of the D band and G band peaks, were determined.

Next, the hardness H_{IT} and elastic modulus E_{IT} of the DLC coating were measured by the nanoindentation method in accordance with the international standard ISO 14577 using a nanoindenter (manufactured by Elionix, model number ENT-1100a). From the obtained measurements, the ratio of hardness to elastic modulus, H_{IT}/E_{IT}, was calculated.

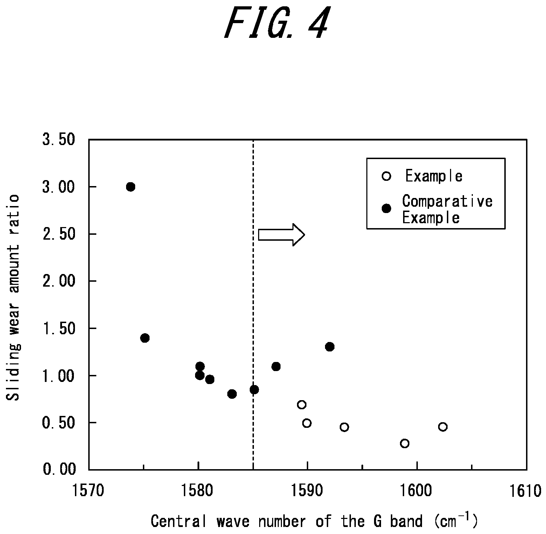

Next, using the sliding fatigue tester illustrated in FIG. 3, the amount of sliding wear of the DLC coating on the piston ring was measured under the above-described test conditions. For the measurement, a test piece having a length of about 20 mm including the outer circumferential surface was cut from a piston ring sample and used. In the sliding wear test, the amount of wear was measured after 10 cycles of one-hour testing, and the ratio of the amount of wear to the amount of wear in Comparative Example 1, which served as a benchmark, was calculated to obtain the sliding wear amount ratio. The evaluation results are listed in Table 2. FIGS. 4 to 7 respectively illustrate the how the central wave number of the G band, the hardness H_{IT}, the ratio H_{IT}/E_{IT}, and the ratio ID/IG listed in Table 2 each relate to the sliding wear amount ratio listed in Table 2.

**[Table 2]**

| | Raman spectroscopy | | H_{IT} (GPa) | E_{IT} (GPa) | H_{IT}/E_{IT} | Sliding wear ratio |
|---|---|---|---|---|---|---|
| | Central wave number of G band (cm⁻¹) | ID/IG | | | | |
| Example 1 | 1589.5 | 1.23 | 33.4 | 297.3 | 0.112 | 0.68 |
| Example 2 | 1602.4 | 1.73 | 25.7 | 223.9 | 0.115 | 0.45 |
| Example 3 | 1598.9 | 3.39 | 17.0 | 178.9 | 0.095 | 0.28 |
| Example 4 | 1593.3 | 1.47 | 28.4 | 258.9 | 0.110 | 0.45 |
| Example 5 | 1589.8 | 3.75 | 20.9 | 210.9 | 0.110 | 0.49 |
| Comparative Example 1 | 1580.1 | 1.82 | 24.9 | 269.1 | 0.092 | 1.00 |
| Comparative Example 2 | 1585.0 | 3.38 | 11.5 | 111.1 | 0.104 | 0.85 |
| Comparative Example 3 | 1575.0 | 1.36 | 31.5 | 345.0 | 0.091 | 1.40 |
| Comparative Example 4 | 1580.1 | 1.62 | 29.0 | 308.0 | 0.094 | 1.10 |
| Comparative Example 5 | 1573.8 | 0.91 | 39.6 | 394.6 | 0.100 | 3.00 |
| Comparative Example 6 | 1581.0 | 2.78 | 21.0 | 219.0 | 0.096 | 0.95 |
| Comparative Example 7 | 1583.0 | 4.78 | 12.0 | 122.2 | 0.098 | 0.80 |
| Comparative Example 8 | 1587.0 | 3.83 | 14.5 | 146.5 | 0.099 | 1.10 |
| Comparative Example 9 | 1592.0 | 5.32 | 8.0 | 65.0 | 0.124 | 1.30 |

| | | | | | | |
|---|---|---|---|---|---|---|
| Underlining indicates a value outside the range of the present disclosure. | | | | | | |

According to Table 2 and FIG. 4, among the piston rings whose central wave number of the G band was 1585 cm⁻¹ or more, those of Examples 1 to 5 had significantly smaller amounts of sliding wear than that of Comparative Example 1, which had a DLC coating according to a conventional technique and was used as the standard for comparison. The sliding wear amounts of the piston rings of Comparative Examples 2 to 7, in which the central wave number of the G band did not exceed 1585 cm⁻¹, were either larger than those of Comparative Example 1, or slightly smaller but with no observable significant improvement. Furthermore, in Comparative Examples 8 and 9, the hardness of the DLC coating, described below, was insufficient, and the amount of sliding wear increased compared to Comparative Example 1.

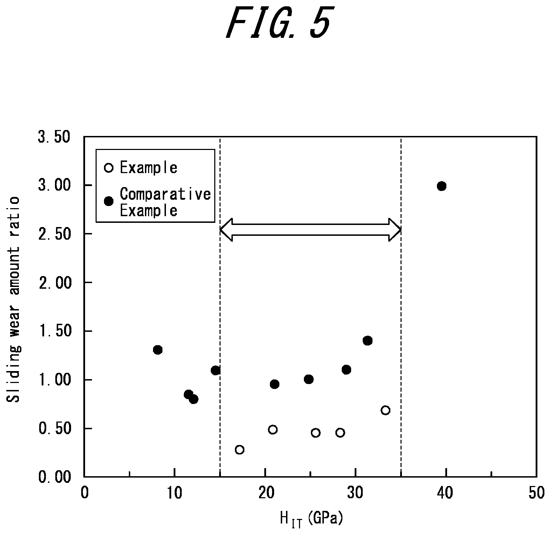

According to Table 2 and FIG. 5, among the piston rings in which the hardness H_{IT} of the DLC coating was 15 GPa or more and 35 GPa or less, those of Examples 1 to 5 had significantly less sliding wear than that of Comparative Example 1. In Comparative Examples 3, 4 and 6, the central wave number of the G band was smaller than 1585 cm⁻¹ as described above, and therefore the sliding wear amount was not significantly smaller than that of Comparative Example 1. From the above results, it is clear that the sliding member according to the present disclosure has superior wear resistance compared to conventional techniques, and that the coating formation speed can be increased by appropriately adjusting the coating formation conditions.

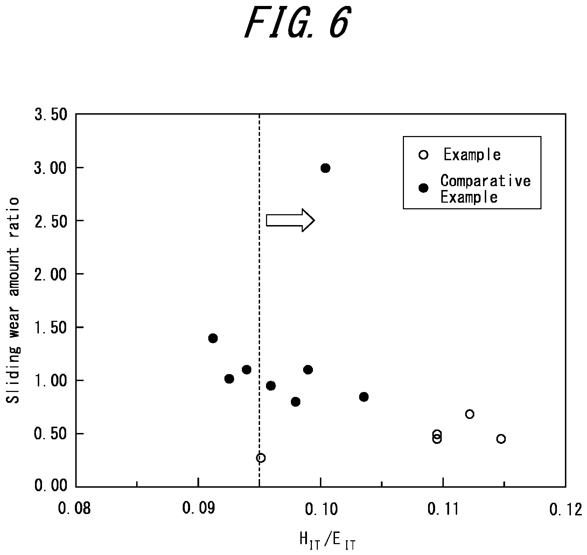

Next, according to FIG. 6, a good correlation was observed between the ratio of hardness to elastic modulus, H_{IT}/E_{IT}, and the sliding wear amount ratio, except for Comparative Example 5, which had an extremely high hardness; also, the sliding wear amount was smaller than that of Comparative Example 1 when H_{IT}/E_{IT} was in the range of 0.095 or more. This suggests that when comparing DLC coatings having the same hardness, the smaller the elastic modulus E_{IT}, the more flexible the DLC coating is with respect to repeated loads, thereby reducing the amount of sliding wear.

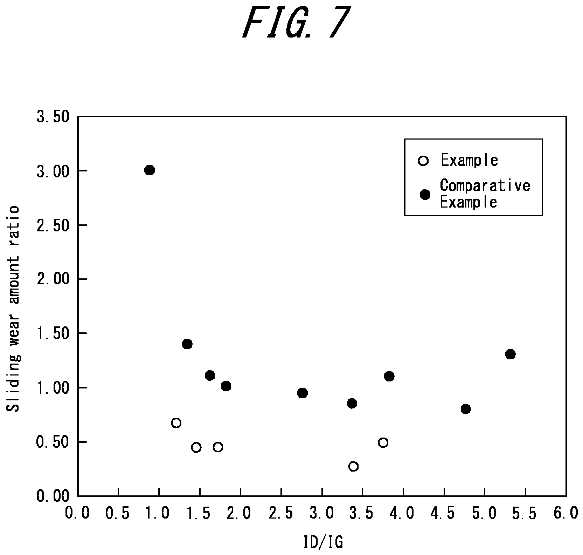

On the other hand, according to Table 2 and FIG. 7, no clear correlation was found between ID/IG, which is the area intensity ratio of the D band and G band peaks described in PTL 1, and the sliding wear amount ratio.

As described above, the DLC coatings of Examples 1 to 5, which exhibited good wear resistance, were all formed under conditions where the set bias was 0 V or a floating potential and the self-bias voltage was approximately 0 V to -35 V, without heating the base member with a heater. In contrast, in the DLC coating of Comparative Example 4, in which the set bias was set to a non-zero value similar to the conventional coating formation conditions, the central wave number of the G band did not reach 1585 cm⁻¹ or more, and the sliding wear ratio did not improve. This is believed to be due to the tendency for hard sp³ clusters to increase in DLC coatings deposited at non-zero set biases.

As for heating by a heater, it is preferable to adjust the temperature of the base member only by heating with an arc current, without use of a heater. This is thought to be because heating with a heater tends to increase the adhesion of foreign matter such as macroparticles from the coating formed on locations other than the base member during coating formation, leading to an increase in the amount of wear. As described above, in the sliding member according to the present disclosure, excellent sliding friction characteristics can be obtained by adjusting the coating formation conditions for DLC coating formation listed in Table 1 so that the characteristics such as the central wave number of the G band and the hardness H_{IT} fall within predetermined ranges.

### REFERENCE SIGNS LIST

- 100: Sliding member
- 10: Base member
- 12: DLC coating
- 200: Piston ring
- 20: Base member
- 22: Outer circumferential surface
- 24a, 24b: Side
- 26a, 26b: Outer circumferential edge
- 28: Inner circumferential surface
- 300: Sliding fatigue tester
- 30: Drum
- 32: Test piece
- 34: Fuel supply pipe

## Claims

1. A sliding member comprising a base member and a DLC coating that is substantially free of hydrogen and is formed on a surface of the base member, wherein
a central wave number of a G band in a Raman spectrum of the DLC coating obtained by Raman spectroscopy using a laser in a visible region as excitation light is 1585 cm⁻¹ or more, and
a hardness H_{IT} of the DLC coating, obtained by nanoindentation and expressed in gigapascals, is 15 GPa or more and 35 GPa or less.

2. The sliding member according to claim 1, wherein E_{IT} is an elastic modulus of the DLC coating, obtained by nanoindentation and expressed in gigapascals, and a ratio H_{IT}/E_{IT} of the hardness H_{IT} to the elastic modulus E_{IT} is 0.095 or more.

3. The sliding member according to claim 1 or 2, further comprising an intermediate layer between the base member and the DLC coating, the intermediate layer being made of one or more elements selected from the group consisting of Cr, Ti, Co, V, Mo, Si, and W, or made of a carbide, nitride, or carbonitride thereof.

4. A piston ring comprising the sliding member according to any one of claims 1 to 3.
